# EUROPEAN PATENT APPLICATION

(11) **EP 1 763 094 A2**
(43) Date of publication of application: **14.03.2007**
(21) Application number: 06392010.2
(22) Date of filing: 05.09.2006
(51) Int. Cl.: H01L 43/12

(54) **Structure and fabrication of an MRAM cell**

(30) Priority: 07.09.2005 US 221146
(71) Applicant: MagIC Technologies Inc., Milpitas, CA 95035 (US)
(72) Inventor: Liubo, Hong, San Jose, CA 95120 (US); Mao-Min, Chen, San Jose, CA 95120 (US); Tai, Min, San Jose, CA 95135 (US); Jun, Chen, Fremont, CA 94538 (US)
(74) Representative: Schuffenecker, Thierry

(57) **Abstract**

MTJ stacks formed using prior art processes often fail because of shorts between the pinned layer and the top electrode. This problem has been overcome by depositing a protective layer on the MTJ sidewalls followed by an inter-layer dielectric. Then planarizing until the protective layer is just exposed. Finally, an etching (or second CMP) process is used to selectively remove the protective layer from the top surface of the cap layer.

## Description

### Technical field

The invention relates to the general field of magnetic random access memories (MRAMs) with particular reference to protecting magnetic tunnel junctions (MTJs).

### Background Art

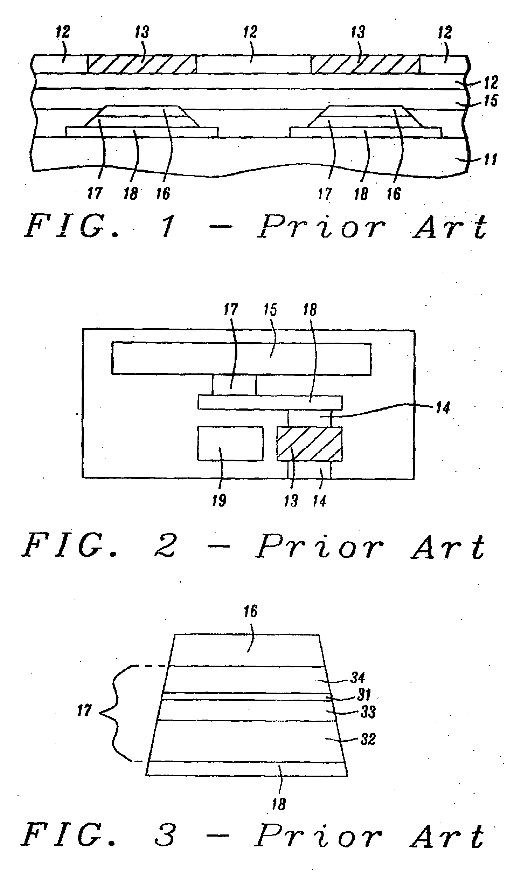

An MRAM chip consists of arrays of MRAM cells connected by bit lines and word lines. Each cell has at least one magnetic junction that is formed between at least two current carrying conductor lines. The magnetic junction of the cell stores information in the form of different magnetic states. FIG. 1 shows a cross-sectional view of two adjacent MRAM cells on common substrate 11. The three parts of the cell that are shown in FIG.1 are bottom electrode 18, active region 17 (presented in greater detail in FIG. 3), and cap layer 16. Word lines are shown here as being above bit line 15 but may also be formed below bottom electrodes, as shown schematically in FIG. 2 as 19. Note that all regions labeled 12 represent insulation while the two regions labeled 14 represent conductive vias.

For the sake of simplification, other circuits, located below and above the magnetic junctions, are not shown in FIGs. 1 and 2. FIG. 3 shows a typical magnetic tunneling junction consisting of seed layer(s)18, antiferromagnetic (AFM) pinning layer 32, ferromagnetic pinned layer (or layers) 33, dielectric tunneling barrier layer (or layers) 31, a ferromagnetic free layer (or layers) 34, and capping layer (or layers) 16. The capping layers may include hard mask materials, such as Ta, that were used for etching and/or as chemical mechanical polishing (CMP) stop layers.

The magnetization direction of the free layer(s) can be either parallel or antiparallel to that of the pinned layers, thereby representing two states that have different electrical resistance values for tunneling through the dielectric barrier layer(s). During a read operation, the information is read by sensing the magnetic state (resistance level) of the junction through a sensing current flowing through the junction. In a write operation, the information is written to the junction by changing the magnetic state (resistance level) to the appropriate one by the magnetic field generated by the combined bit and word line currents.

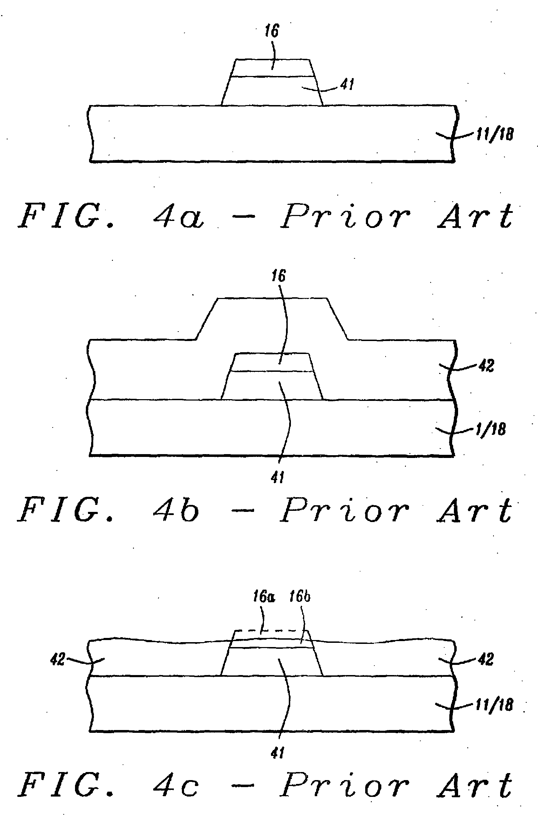

When fabricating high density MRAM chips, it is desirable to have a generally flat topography after each layer has been completed -- usually through a CMP process. For the MTJ layer in particular, CMP is used to provide generally flat topography and to expose the top surface of the MTJ structure for electrical contact. As shown in FIG. 4a, the films that make up the storage element are first patterned by an etch process. The cap, includes a CMP stop layer. Next, a layer of silicon oxide is deposited over the full wafer to cover the etched areas and the MTJ junctions (FIG. 4b). Then, a CMP process polishes the oxide away from the top of the device (FIG. 4c). Part of the cap's top is also removed by the CMP process due to limited CMP selectivity, said part being shown as dotted lines in FIG. 4c.

There are two major problems associated with the conventional CMP process just described. First, CMP usually leads to thinning of the oxide around the MTJ stack including the tunneling junction itself. The amount of thinning varies significantly from device to device and from wafer to wafer, being in the range of 400 Å and above. When the amount of oxide thinning is large enough, the layers below the tunnel barrier become exposed and can thus be short circuited to the top electrode (bit line in FIGs. 1 and 2). In some designs a very thick capping layer is used to prevent this kind of MTJ junction shorting, but this comes at the cost of increased bit line to free layer distance and reduced bit line writing efficiency.

A routine search of the prior art was performed with the following references of interest being found:
U.S. Patent 6,806,096 (Kim et al) discloses nitride over the cap layer, oxide fill, and CMP. U.S. Patent 6,881,351 (Grynkewich et al) describes depositing plasma-enhanced nitride, then oxide over the MTJ stack, then CMP. U. S. Patent 6,174,737 (Durlam et al) describes forming a dielectric layer over the MTJ stack and planarizing by CMP. In US 6,713,802, Lee uses a hard mask to pattern his layer.
U. S. Patent 6,858,441 (Nuetzel et al) discloses depositing a nitride layer, then a resist layer used in CMP of conductive material forming alignment marks after forming MTJ elements. U. S. Patents 6,815,248 (Leuschner et al) and 6,783,999 (Lee) show using nitride or oxide as a fill material over MTJ elements, then CMP. U.S. Patent 6,784,091 (Nuetzel et al) teaches planarizing a blanket nitride layer on top of the MTJ stack.
Tuttle et al., in US 6,852,550, rely on slag residue 110 to protect the MTJ tunneling layer, do not use CMP, leave an etch mask 80 in place on top of the cap layer, and require the tunneling layer to form a step relative to the free layer.

### Summary of the invention

It has been an object of at least one embodiment of the present invention to protect an MTJ against shorting caused by thinning of the layer of silicon oxide of the prior art.

Another object of at least one embodiment of the present invention has been to provide a capping layer for the MTJ that has minimal thickness, thereby minimizing the bit line to free layer distance and improving bit line writing efficiency.

Still another object of at least one embodiment of the present invention has been that said capping layer not be required to include a CMP stop layer.

A further object of at least one embodiment of the present invention has been to prevent MTJ deterioration caused by subsequent annealing.

A still further object of at least one embodiment of the present invention has been to provide a process that achieves the above objects without introducing substantial changes into existing methods for manufacturing MTJ based MRAM cells.

These objects have been achieved by depositing a protective layer on the MTJ sidewalls followed by a layer of silicon oxide or other inter-layer dielectric. Then planarizing until this protective layer is just exposed. Finally, an etching process is used to selectively remove the protective layer from the top surface of the cap layer. Alternatively, planarization may be used and terminated when the capping layer is just exposed.

### Description of the drawings

FIG. 1 shows a pair of prior art MRAM cells based on MTJs.
FIG. 2 shows the word lines seen in FIG. 1 located beneath the MTJ.
FIG. 3 illustrates the principal layers that make up an MTJ stack.
FIGs. 4a - 4c show how the devices seen in FIGs. 1 and 2 are manufactured according to prior art processes.

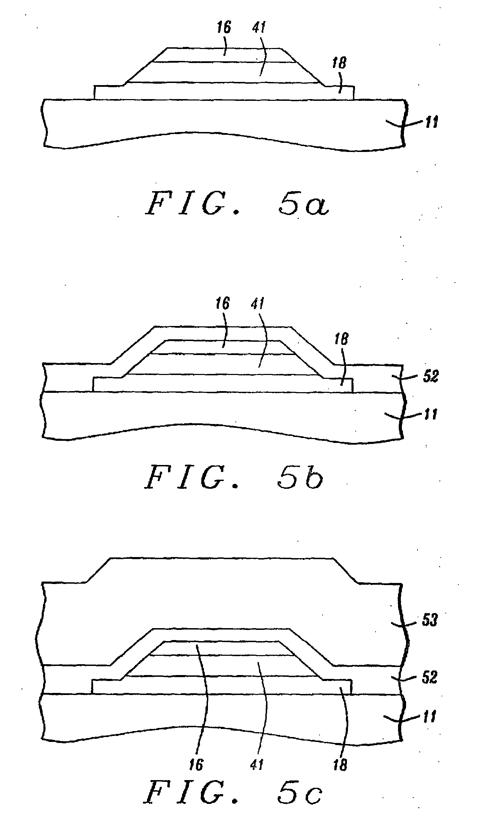

FIG. 5a shows the starting point for the process of the present invention.
FIG. 5b shows the deposition of a protective layer that covers all exposed surfaces.

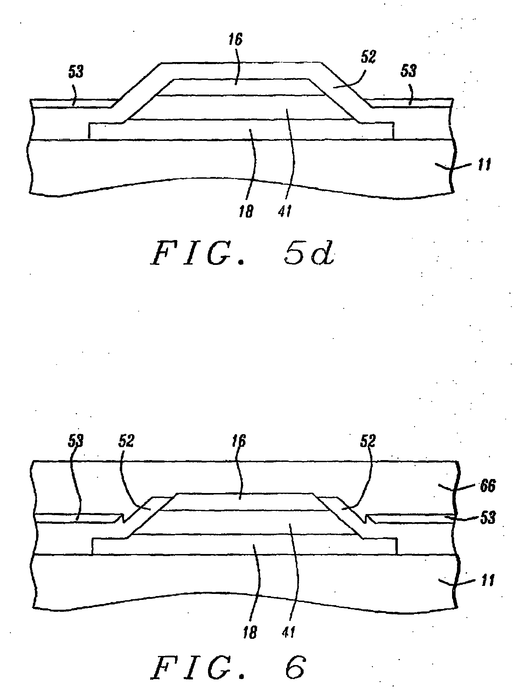

FIGs. 5c and 5d illustrate the deposition of a layer of silicon oxide on the structure of FIG. 5b, followed by CMP which, at termination, removes all silicon oxide from over the MTJ's.
FIG. 6 shows the completed structure of the invention.

### Description of the preferred embodiments

As noted earlier, in the prior art the exact stopping point for the CMP in the capping layer cannot be well controlled, varying from device to device and from wafer to wafer. As a result, control of the distance between the bit line and the free layer(s) is poor. Because the strength of the magnetic field generated by the bit line current at the free layer(s) depends strongly on the distance between the bit line and free layer(s), the inability to control this distance translates directly to the inability to control the switching magnetic field at the free layer(s), leading to degradation of device performance.

The present invention solves this problem through a new process to fabricate the MRAM chips that results in a MRAM cell structure with reduced MTJ shorting and a well controlled distance from bit line to free layers. In this process, a layer of silicon nitride or silicon oxynitride is deposited on the patterned MTJ junctions for extra protection, before the deposition of the inter-layer dielectric that precedes the CMP process.

The innovative portion of the invention begins as illustrated in FIG. 5a where an MRAM cell is shown at the stage where the MTJs have just been patterned. The cap part of the MTJ stack does not include a CMP stop layer as would be the case in the prior art process which the present invention aspires to replace. Then, as shown in FIG. 5b as a key novel feature of the invention, protective layer 52, of silicon nitride or silicon oxy-nitride, is deposited over the entire structure to protect the MTJ junctions. Then layer 53 of silicon oxide is deposited over the protective layer, as shown in Fig. 5c.

CMP is then used in the usual way to achieve global planarization, so as to remove all silicon oxide from above the MTJ stacks. Since the protective layer, being made of silicon nitride or silicon oxynitride, is polished at a much slower rate than the silicon oxide (1:10 or less), the CMP process removes all oxide that is above the MTJ stacks, but leaves a certain amount of the original protective layer in place above the MTJ stacks.

The silicon oxide surface a short distance away from the MTJ stacks is lower than the protective layer silicon nitride or silicon oxtnitride on top of the MTJ stacks as a result of the polish rate difference, as shown in FIG. 5d. Very little of protective layer 52 that surrounds the MTJ is removed due to its low polishing rate. Layer 52 serves to protect the tunnel junction's barrier layer as long as the surface of silicon oxide layer 53 remains below said tunnel barrier's level. Thus, the MTJ layers below the tunnel barrier will not be exposed nor can they be unintentionally shorted to top electrode 66 (as seen in FIG. 6). These features constitute an important departure from (and improvement over) the prior art.

After CMP, an etch process is used to selectively remove the protective layer from over the MTJ stacks. Said etch process is chosen to be highly selective with respect to the surrounding material (about 10:1 relative to silicon oxide and between about 10-20:1 relative to the MTJ cap material). Thus, only a very small amount of MTJ cap material gets removed during this high selectivity etch process. SiNX material around MTJ stacks will be removed relative to the MTJ stack due to over etching, but the amount involved is small and well controlled. Our preferred selective etch for this purpose has been reactive ion etching together with a fluorine based plasma, but other etch processes having similar differential etch rates could also have been used.

As an alternative to removing part of layer 52 by etching after the CMP step illustrated in FIG 5d, another CMP step, based on a different chemistry, may be used to remove all of protective layer 52 on top of the MTJ.

As shown in FIG. 6, when the process of the invention is used as described above, even if some oxide is removed to a level that is below that of the tunnel barrier layer, there still can be no shorting between the MTJ layers below barrier layer to the top electrode. It is important to note that the MTJ cap layers do not need to be made thicker, to prevent possible shorting, as is the case with the prior art process. Additionally, there is now a larger CMP process tolerance window than that associated with the prior art.

The new MRAM structure fabricated using the process of the present invention is shown in FIG. 6. The layers below bottom electrode 18 or above top electrode 66 are not shown. This new structure has less shorting and has better controlled top electrode to MTJ free layer distance than is achievable by the prior art.

The fact that the material in contact with the MTJ is silicon nitride or silicon oxynitride, rather than SiO₂, is important for another reason. It had been noticed in prior art structures that the MTJ resistance increased significantly if the device was subjected to a temperature greater than about 250 °C. This has been traced to the influence of oxygen atoms that diffuse into the junction from the silicon oxide contacting layer. When that layer is replaced by silicon nitride (or oxynitride) this increase of MTJ resistance on heating disappears and the coated MTJ can be heated to temperatures as high as about 280 °C for up to about 10 hours without significantly affecting the MTJ resistance.

As discussed earlier the structure of the present invention may be one of several different possible MRAM configurations so that the word line may be located above the bit line, or vice versa.

## Claims

1. A process to manufacture an MRAM cell comprising:
providing a MTJ having sidewalls, an insulated tunneling layer, and a cap layer disposed to lie above said insulated tunneling layer;
by means of a conformal coating process, depositing a protective layer, having a top surface, onto all exposed surfaces, thereby covering said cap layer and said sidewalls;
depositing a inter-layer dielectric on said protective layer;
planarizing by means of CMP until said protective layer is just exposed, whereby, due to differences in polishing rate, said inter-layer dielectric acquires a surface that is lower than said protective layer surface; and
by means of an etching process, selectively removing said protective layer until said cap layer is just exposed, thereby giving said MRAM cell the ability to be heated to temperatures as high as about 280°C for up to about 10 hours without significantly affecting MTJ resistance.

2. The process described in claim 1 wherein said protective layer is silicon nitride or silicon oxynitride.

3. The process described in claim 1 wherein said inter-layer dielectric is silicon oxide.

4. The process described in claim 2 wherein said conformal coating process used to deposit said protective layer further comprises plasma enhanced CVD or atomic layer CVD.

5. The process described in claim 2 wherein said cap layer is selected from the group consisting of Ta, Ru, TaN, Ti, TiN, and WN, and is deposited to a thickness between about 30 and 500 Angstroms.

6. The process described in claim 2 wherein said protective layer is deposited to a thickness between about 30 and 400 Angstroms.

7. The process described in claim 2 wherein said etching process, used to selectively remove said protective layer, further comprises using reactive ion etching together with a fluorine based plasma, whereby an etch rate is achieved that is at least 10 times faster for the protective layer than for the silicon oxide layer and between about 10 and 20 times faster for the protective layer than for the cap layer.

8. A process to manufacture an MRAM cell comprising:
providing a MTJ having sidewalls, an insulated tunneling layer, and a cap layer disposed to lie above said insulated tunneling layer;
by means of a conformal coating process, depositing a protective layer, having a top surface, onto all exposed surfaces, thereby covering said cap layer and said sidewalls;
depositing a inter-layer dielectric on said protective layer;
planarizing by means of a first CMP process until said protective layer is just exposed, whereby, due to differences in polishing rate, said inter-layer dielectric acquires a surface that is lower than said protective layer surface; and
by means of a second CMP process, based on a different chemistry from that of said first CMP process, selectively removing said protective layer until said cap layer is just exposed, thereby giving said MRAM cell the ability to be heated to temperatures as high as about 280 °C for up to about 10 hours without significantly affecting MTJ resistance.

9. The process described in claim 8 wherein said protective layer is silicon nitride or silicon oxynitride.

10. The process described in claim 8 wherein said inter-layer dielectric is silicon oxide.

11. The process described in claim 9 wherein said conformal coating process used to deposit said protective layer further comprises using plasma enhanced CVD or atomic layer CVD.

12. The process described in claim 9 wherein said cap layer is selected from the group consisting of Ta, Ru, TaN, Ti, TiN, and WN, and is deposited to a thickness between about 30 and 500 Angstroms.

13. The process described in claim 9 wherein said protective layer is deposited to a thickness between about 30 and 400 Angstroms.

14. An MRAM cell comprising:
a MTJ having sidewalls, an insulated tunneling layer, and a cap layer disposed to lie above said insulated tunneling layer; and
a protective layer that covers layers beneath said tunneling layer, including said insulated tunneling layer, but not including a top surface of said cap layer, whereby a short circuit between said sidewalls and said cap layer is not possible.

15. The MRAM cell described in claim 14 wherein said protective layer is silicon nitride or silicon oxynitride.

16. The MRAM cell described in claim 14 wherein said cap layer is selected from the group consisting of Ta, Ru, TaN, Ti, TiN, and WN, and is deposited to a thickness between about 30 and 500 Angstroms.

17. The MRAM cell described in claim 14 wherein said protective layer has a thickness between about 30 and 400 microns.

18. The MRAM cell described in claim 15 wherein said MRAM cell may be heated to temperatures as high as about 280 °C for up to about 10 hours without significantly affecting MTJ resistance.
